Europäisches Patentamt

European Patent Office

Office européen des brevets

(11) Publication number: **0 463 331 A2**

# EUROPEAN PATENT APPLICATION

(21) Application number: **91107385.6**

(22) Date of filing: **07.05.91**

(51) Int. Cl.⁵: **G11C 16/06**

(30) Priority: **28.06.90 US 546203**

(43) Date of publication of application:
**02.01.92 Bulletin 92/01**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Kaya, Cetin
9900 Adleta Blvd., Apt. No. 1114
Dallas, Texas 75243(US)**

(74) Representative: **Leiser, Gottfried, Dipl.-Ing. et
al
Patentanwälte Prinz, Leiser, Bunke & Partner
Manzingerweg 7
W-8000 München 60(DE)**

(54) **An improved method for programming a non-volatile memory.**

(57) An improved method is provided for program-
ming a non-volatile memory cell formed at a face of
a layer of semiconductor 12 of a first conductivity
type and having a source region 14 in a drain 16 of
a second conductivity type spaced by a channel 18.
A floating gate 22 is disposed insulatively adjacent
channel 18 and a control gate 24 is disposed in-
sulatively adjacent floating gate 22. The source re-
gion 14 is grounded while a first voltage is applied to
the drain region 16. A time varying voltage pulse is
applied to the control gate such that the potential of
floating gate 22 remains substantially constant as
electrons are accumulated on floating gate 22.

*FIG. 3*

EP 0 463 331 A2

## TECHNICAL FIELD OF THE INVENTION

The present invention relates generally to non-volatile memory devices, and more particularly to an improved method and circuitry for programming non-volatile memories.

## BACKGROUND OF THE INVENTION

Electrically-programmable read-only memories (EPROMs) and electrically-programmable, electrically-erasable read-only memories (EEPROMs) are non-volatile semiconductor memory devices based on metal oxide semiconductor field effect transistors (MOSFETs). EPROM and EEPROM cells store a bit of information as a quantity of electrons on a floating gate structure insulatively formed between the channel and the control gate of the field effect transistor. A charged floating gate raises the threshold voltage of the field effect transistor channel above the voltage normally applied to the control gate during the read operation, thereby storing a logic "zero." An uncharged floating gate does not alter the threshold voltage of the channel of the field effect transistor, and therefore a normal gate reading voltage will exceed the threshold voltage thereby storing a logic "one."

One structure used in EPROM cells and some EEPROM cells, is the floating gate avalanche injection metal oxide semiconductor (FAMOS) structure. In this structure, the floating gate is charged by the transport of electrons from either the drain or the source of the field effect transistor by avalanche injection or by channel hot electron injection. An applied high voltage pulse to the control gate induces a conductive inversion layer from source to drain. If, for example, the source is grounded and the drain is pulsed with sufficient voltage, electrons will accelerate through the inversion area in the channel from the source to the drain. A number of these electrons will collide with the semiconductor lattice in the channel and will create electron-hole pairs. A some of the electrons created during this process ("hot" electrons) have a sufficient energy level to jump over potential barrier created by the insulator between the floating gate and the channel. A percentage of these "hot" electrons will in turn be drawn to the floating gate because of the voltage induced on the floating gate due to capacitive coupling with the control gate. These electrons come to reside on the floating gate thereby charging it.

In a conventional method of charging a floating gate by hot electron injection, a square wave, typically between 10 to 100 microseconds in duration, and approximately 12 V in amplitude, is applied to the control gate. Simultaneously, a voltage of approximately 6 V is applied to the drain. Importantly, the speed of programming an EPROM or EEPROM cell is dependent upon the duration of the square wave.

Thus, a need has arisen for a method and circuitry for minimizing the time necessary to program a non-volatile memory cell.

## SUMMARY OF THE INVENTION

According to the invention, a non-volatile memory cell having a source and a drain spaced by a channel, a floating gate insulatively adjacent the channel, and a control gate insulatively adjacent the floating gate, is programmed by applying a first voltage to the source region while a second voltage is applied to the drain region. A time varying voltage pulse is applied to the control gate such that the potential of the floating gate remains substantially constant as electrons are accumulated on the floating gate.

The present invention allows for a substantially constant flow of electrons to the floating gate during the programming process. This eliminates the problem which occurs during conventional programming when the voltage of the floating gate decreases as electrons accumulate on it, the decrease in floating gate voltage thereby causing a decrease in the number of electrons being attracted to the floating gate, which increases the programming time. Further, the voltages are compatible with those already employed in the programming of non-volatile memories.

## BRIEF DESCRIPTION OF THE DRAWINGS

For a more complete understanding of the present invention, and the advantages thereof, reference is now made to the following descriptions taken in conjunction with the accompanying drawings, in which:

FIGURE 1 is an elevational sectional schematic diagram of a non-volatile memory cell;

FIGURE 2a is a voltage versus time plot depicting the parameters of a gate voltage pulse according to a first preferred method;

FIGURE 2b is a voltage versus time plot depicting the parameters of a gate voltage pulse according to a second preferred method; and

FIGURE 3 is an electrical schematic diagram of a small section of an array of non-volatile memory cells according to the invention.

## DETAILED DESCRIPTION OF THE INVENTION

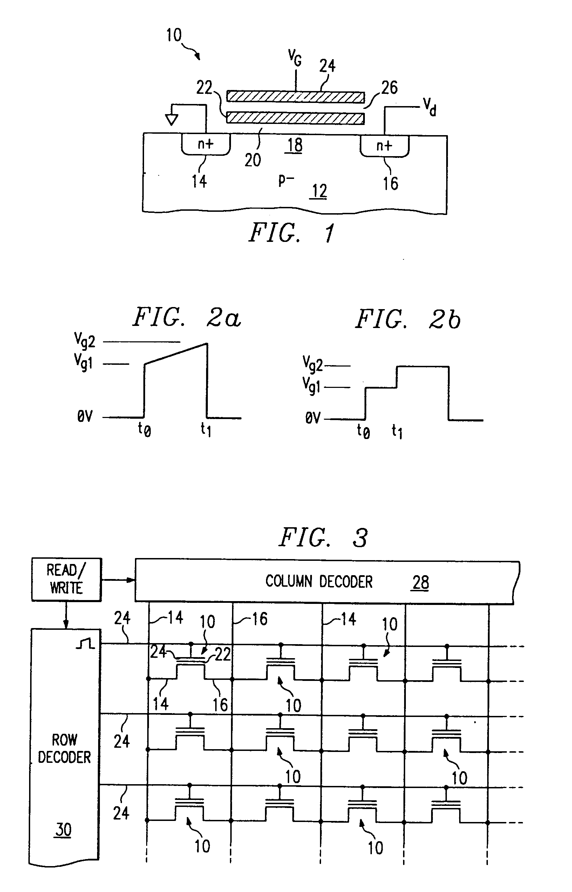

The preferred embodiment of the present invention is best understood by referring to FIGURES 1 to 3 of the drawings like numerals being used for like and corresponding parts of the various drawings.

Referring first to FIGURE 1, a cross sectional schematic of a conventional non-volatile memory cell is shown generally at 10. Memory cell 10 is formed in a p-semiconductor layer 12, and includes n+ source region 14 an n+ drain region 16 separated by a channel 18. A gate oxide layer 20 separates channel area 18 from a floating gate 22. A control gate 24 is formed over the floating gate 22 and separated therefrom by an interlevel insulator 26. Memory cell 10 is generally referred to as an n-channel device, however, the present invention is not limited to n-channel non-volatile memories. For example, a p-channel device in which the semiconductor layer 12 is n-type material, and source 14 and drain 16 are p-type material, may optionally be used. In the case of a p-channel device, the polarity of the voltages used during the programming will be appropriately inverted.

The present invention is best understood by reference to Figure 2a-b and Figure 3. In the first preferred embodiment of programming the cell shown in FIGURE 1, source 14 is grounded and a voltage $V_d$ is applied to drain 16. To ensure the generation of sufficient electron-hole pairs for charging the floating gate 22 by hot electron injection, it is desirable to select voltage $V_d$ in order to maintain as high a source-drain current $I_{ds}$ as possible. The voltage $V_d$ may be pulsed, as is often done in conventional hot electron injection programming. A time varying control gate voltage pulse $V_g$ is then applied to the control gate 24.

In the first preferred method, shown in FIGURE 2a, the voltage pulse $V_g$ applied to control gate 24 approximates a ramp function, wherein the voltage $V_g$ begins at an initial value $V_{g1}$ and then increases in a substantially linear fashion until it reaches a second value $V_{g2}$. To achieve optimal performance, voltages $V_{g1}$ and $V_{g2}$, the slope of the ramp and the pulse width, are selected to maintain a floating gate voltage $V_f$ approximately equal the voltage $V_d$ applied to the drain. The actual selection of the parameters of the control gate pulse $V_g$ is based on the specific structure of the memory cell being programmed. In the case of currently available EPROM memory cells, the control gate voltage pulse might typically ramp from +8V to +12V in between 10 and 100 microseconds. Time required to program the cell may be reduced as much as 50% over the conventional square wave method. For a typical cell, a gate current on the order of 100pA substantially throughout the duration of gate pulse $V_g$ would be desirable. To obtain such a ramp pulse, any one of a number of conventional circuits, such as R-C circuits may be used.

In conventional programming methods, where control gate voltage $V_g$ is applied as a square wave, the voltage $V_f$ on the floating gate 22 will initially be the maximum voltage capacitively coupled from the control gate 24. The number electrons being injected, sometimes designated as the gate current $I_g$, initially increases towards a maximum value corresponding to the maximum voltage coupled to floating gate 22. As the electrons charge floating gate 22, however, the voltage $V_f$ begins to decrease, which in turn reduces the gate current $I_g$. This significantly slows down the programming process.

By using a ramped gate voltage pulse $V_g$, as electrons accumulate on floating gate 22, lowering its potential, the gate voltage $V_g$ is correspondingly being increased to counterbalance the effects of the negative charge of the electrons. Thus, the floating gate potential can be optimized such that the acceleration of electrons across gate oxide 20 by hot electron injection can remain substantially constant at the maximum gate current $I_g$. This allows floating gate 22 to be charged in an efficient fashion, thereby reducing the time it takes to program cell 10 to a logic "zero."

In a second preferred method, similar optimization of the floating gate voltage $V_f$ is obtained using a control gate voltage pulse $V_g$ which includes a step function. A typical pulse according to the second preferred method is shown in FIGURE 2b. Initially, control gate voltage pulse $V_g$ will be at a voltage $V_{g1}$ up until time $t_1$. At time $t_1$, the voltage will be stepped from voltage $V_{g1}$ to $V_{g2}$. Additional voltage steps may be provided to more accurately simulate a ramp function. As in the first preferred method, the step in voltage from $V_{g1}$ to $V_{g2}$ compensates for the decrease of the floating gate voltage $V_g$ due to the accumulation of electrons on floating gate 22. As with the first preferred method, the critical voltages and times are selected to optimize the gate current $I_g$ based on the specific cell structure. Creation of a step function similar to that shown in FIGURE 2 can be created either on or off chip using conventional circuitry well known in the art.

FIGURE 3 depicts a small portion of typical array of non-volatile memory cells formed in columns and in rows. Like designated numbers in FIGURES 1 and 3 designate like parts. In the array, source regions 14, drain regions 16 and channel regions 18 are elongated to form a plurality of parallel columns. Each cell and array is provided with a floating gate 22. Control gates 24 are elongated in a row direction and form a plurality of wordlines which insulatively overlie each floating gate in a respective row of cells.

The elongated source regions 14 and drain regions 16 are coupled to a column decoder 28. While the elongated control gates (wordlines) 24 are coupled to a row decoder 30 which provides the Vg signal. Column decoder 28 is operable to control the voltages on source regions 14 and drain regions 16. Row decoder 30 is provided with conventional circuitry for forming time varying control gate voltage pulses $V_g$ according to the invention. Thus, an array of non-volatile memory cells is provided which has improved speed in charging preselected floating gates 22.

While preferred embodiments of the invention and their advantages have been set forth in the above detailed description, the invention is not limited thereto, but only by the scope and spirit of the appended claims.

**Claims**

1. A method for programming a non-volatile memory cell formed at a face of a layer of semiconductor of a first conductivity type, and including first and second diffused regions of a second conductivity type spaced by a channel, a floating gate insulatively adjacent the channel, and a control gate insulatively adjacent the floating gate, comprising the steps of:
    applying a first voltage to the first diffusion region;
    applying a second voltage to the second diffused region; and
    applying a time varying voltage pulse to the control gate such that the potential of the floating gate remains substantially constant as electrons are injected on to the floating gate.

2. The method of Claim 1, wherein the time varying voltage pulse is shaped to maintain the potential of the floating gate at a level approximating the voltage being applied to the second diffused region.

3. The method of Claim 1, wherein the time varying voltage pulse is substantially a ramp function from a third voltage to a fourth voltage.

4. The method of Claim 3, wherein said third voltage is less than said fourth voltage.

5. The method of Claim 1, wherein the time varying voltage pulse includes a step function from a third voltage to a fourth voltage.

6. The method of Claim 5, wherein said third voltage is less than said fourth voltage.

7. A method for programming a floating gate avalanche injection metal oxide semiconductor non-volatile memory cell, including a source and a drain region spaced by a channel, a floating gate insulatively overlying the channel, and a control gate insulatively overlying the floating gate, comprising the steps of:
    applying a first voltage to the drain region;
    applying a second voltage to the source region to create a current between the source and the drain; and
    applying a time varying voltage pulse to the control gate to induce a voltage on the floating gate such that a substantially constant gate current is generated between the channel and the floating gate.

8. The method of Claim 7, wherein the voltage pulse increases in a substantially linear manner from a third voltage to a fourth voltage.

9. The method of Claim 8, wherein the first voltage is approximately 8 volts and the second voltage is approximately 12 volts.

10. The method of Claim 9, wherein the voltage pulse has a time duration in the range of 10 to 100 microseconds.

11. The method of Claim 7, wherein the voltage pulse amplitude steps up from a first lower voltage to a second higher voltage.

12. A method of programming a non-volatile memory by hot electron injection into a floating gate, comprising the steps of:
    generating a voltage differential between source and drain regions; and
    controlling the voltage of the floating gate to counter deviations in the floating gate voltage away from an optimum voltage.

13. The method of Claim 12, wherein said controlling step comprises the step of applying a voltage signal to a control gate which is electrically coupled to the floating gate.

14. The method of Claim 13, wherein said applying step comprises the step of applying a voltage signal to the control gate which varies as a function of time.

15. The method of Claim 14, wherein said step of applying a variable voltage signal comprises the step of applying a voltage signal to the control gate which varies substantially linearly with time.

16. The method of Claim 14, wherein said step of applying a variable voltage signal comprises the step of applying a step voltage signal.

17. The method of Claim 12, wherein the optimum voltage equals the voltage at which the gate current is maximized.

18. The method of Claim 12, wherein the optimum floating gate voltage is approximately equal to the voltage applied to the drain.

19. A memory cell array comprising:
a plurality of non-volatile memory cells each having a control gate, a floating gate, a source and a drain; and
control circuitry coupled to said cells operable to apply a time-varying voltage pulse to selected said control gates such that respective floating gates associated with said selected control gates are charged with a substantially constant gate current.

20. The memory cell array of Claim 19, wherein said control circuitry is operable to apply a time-varying voltage pulse which ramps in a substantially linear fashion from a first voltage to a second voltage.

21. The memory cell array of Claim 20, wherein said control circuitry is operable to apply a time-varying voltage pulse which steps from a first voltage to a second voltage.

22. An array of non-volatile memory cells formed in columns and in rows at an angle to the columns, at the face of a layer of semiconductor of a first conductivity type, comprising:
for each column, an elongated drain region of a second conductivity type opposite said first conductivity type, forming a first bit line;
for each column, an elongated source region of said second conductivity type forming a second bit line substantially and parallel to said first bit line and spaced therefrom by a channel;
for each cell, a floating gate insulatively adjacent a portion of a respective channel;
for each row, an elongate control gate insulatively adjacent said floating gates in said row, forming a wordline; and
a row decoder coupled to said wordlines in said array, said row decoder operable to apply a time varying voltage pulse to said wordlines.

23. The array of Claim 12, wherein said row decoder is operable to apply a time varying voltage pulse which ramps in a substantially linear fashion from a first voltage to a second voltage.

24. The array of Claim 12, wherein said row decoder is operable to apply a time varying voltage pulse which includes a voltage step from a first voltage to a second voltage.

FIG. 1

FIG. 2a

FIG. 2b

FIG. 3